# EUROPEAN PATENT SPECIFICATION

(11) **EP 3 298 627 B1**
(45) Date of publication and mention of the grant of the patent: **06.11.2024**
(21) Application number: 16726047.0
(22) Date of filing: 19.05.2016
(51) Int. Cl.: G09F 3/20, G09F 9/30, H10K 59/10, H10K 59/60, G09F 3/02

(54) **PACKAGING LABEL AND METHOD FOR LABELLING A PACKAGE**
VERPACKUNGSETIKETT UND VERFAHREN ZUR ETIKETTIERUNG EINER VERPACKUNG
ÉTIQUETTE D'EMBALLAGE ET PROCÉDÉ D'ÉTIQUETAGE D'UN EMBALLAGE

(30) Priority: 20.05.2015 IT UB20150644
(43) Date of publication of application: 28.03.2018
(73) Proprietor: Fondazione Istituto Italiano di Tecnologia, 16163 Genova (IT); Politecnico di Milano, 20133 Milano (IT)
(72) Inventor: CAIRONI, Mario, 20131 Milano (IT); CARVELLI, Marco, 20161 Milano (IT); IACCHETTI, Antonio, 26012 Castellone (CR) (IT); DELL'ERBA, Giorgio, 70125 Bari (IT)
(74) Representative: Murgitroyd & Company
(86) International application number: PCT/EP2016/061324
(87) International publication number: WO 2016/184982

(56) References cited:
- US-A1- 2011 096 388
- US-A1- 2011 317 121
- US-A1- 2012 168 910
- US-A1- 2012 326 131
- US-A1- 2015 108 508
- BERND TIEKE ED - MILLER REINHARD ET AL: "Coordinative supramolecular assembly of electrochromic thin films", CURRENT OPINION IN COLLOID & INTERFACE SCIENCE, LONDON, GB, vol. 16, no. 6, 20 June 2011 (2011-06-20), pages 499 - 507, XP028114218, ISSN: 1359-0294, [retrieved on 20110729], DOI: 10.1016/J.COCIS.2011.07.002
- ANONYMOUS: "Transistor - Wikipedia", 18 December 2003 (2003-12-18), XP093022970, Retrieved from the Internet <URL:https://en.wikipedia.org/wiki/Transistor> [retrieved on 20230210]

## Description

The present invention relates to a packaging label and to a method for labelling a package.

In the packaging industry labels with fixed graphics are known, i.e. bearing a predetermined message, which may be adhesive or printed directly onto the packaging, for example a plastic or glass bottle.

However, such labels have the disadvantage of being able to produce only one message (e.g. product name, list of ingredients, promotional message), therefore for many commercial products, it is necessary to use a plurality of different labels, each dedicated to specific contents.

In the field of electronics on plastic, dynamic labels are also known, provided with a display for displaying a plurality of different messages, such as, for example, a promotional message, the expiry date and/or the ingredients of the packaged product. However, such labels are not fully comprised of materials compatible with recycling (including the display) and the production process is not compatible with high performance printing or with direct printing on the packaging container. Furthermore, such labels must be self-supplied and not even the supply unit satisfies the above indicated requirements. Documents US 2015/108508 A1, US 2012/326131 A1, US 2011/317121 A1 and US 2011/096388 A1 disclose examples of packaging labels according to prior art.

Therefore, there is a need to find innovative solutions to the problem of "dynamically" labelling packaged products, mainly for marketing and advertising purposes.

The object of the invention is therefore to propose a dynamic label able to progressively change the contents displayed, which may be directly printed and/or integrated onto the packaging and which is compatible with current packaging production processes, by adding to the packaging itself a negligible cost in order to be economically sustainable.

A further object of the invention is that of proposing an easily recyclable label.

These and other objects are reached with a label whose characteristics are defined in claim 1.

Particular embodiments form the subject matter of the dependent claims, whose contents are to be considered an integral part of the present description.

Further characteristics and advantages of the invention will appear from the following detailed description, given by way of non-limitative example, with reference to the appended drawings, in which:
- Figure 1 is a schematic front view of a label according to an embodiment not included in the scope of the present invention;
- Figure 2 illustrates a front view of an embodiment of the label of Figure 1;
- Figure 3 shows a sectional view of the label of Figure 1;
- Figure 4 shows the label according to a preferred embodiment of the present invention; and
- Figure 5 shows a block diagram of the operations of the method for obtaining a label according to the present invention.

In summary, a label according to the present invention is fully recyclable, can be printed with high performance printing processes either on plastic or on paper or directly on plastic packaging, for example PET, and can be used with the current packaging industry standards. The label according to the present invention also integrates a source of independent energy.

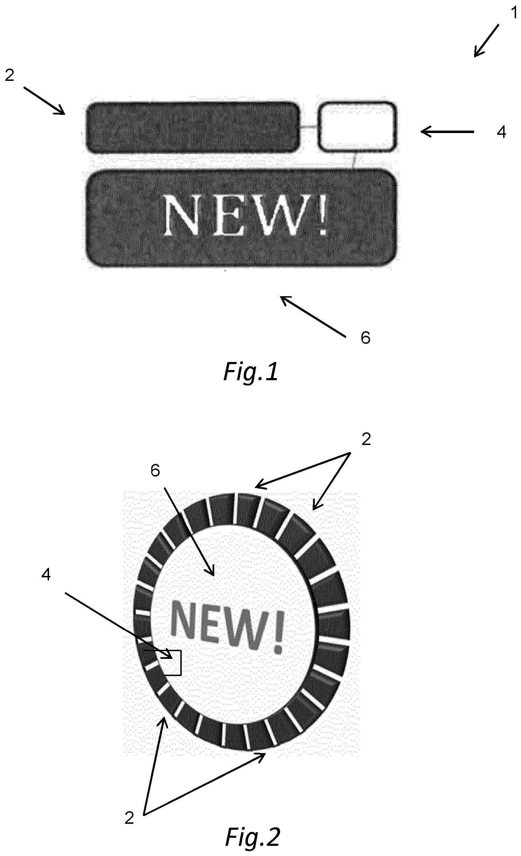

Figure 1 shows a schematic front view of a label 1 not included in the scope of the present invention. Such label 1 comprises at least a photovoltaic source 2 adapted to supply a control module 4 and a display 6 bearing a message.

The photovoltaic source 2 is a photovoltaic module known in itself, which preferably uses a bulk heterojunction organic technology. Alternatively, the photovoltaic source is not organic, being, for example, a photovoltaic source based on quantum dots or hybrid perovskite. The photovoltaic module 2 can be printed, in a known way, on a plastic substrate, for example, polyethylene terephthalate (PET) having a thickness preferably comprised in the interval 1µm - 100 µm.

Figure 2 shows a front view of an embodiment of the label 1, i.e. not included in the scope of present invention, in which there are a plurality of photovoltaic modules 2 arranged along a circumference, the display 6 corresponding to the area containing the message and the control module 4 being next to the display 6 (according to an embodiment of the present invention, the control module 4 is positioned below the display 6 as described in detail below).

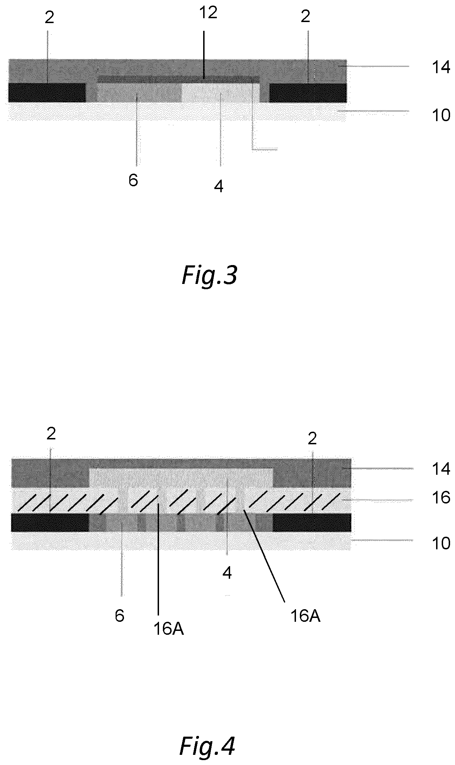

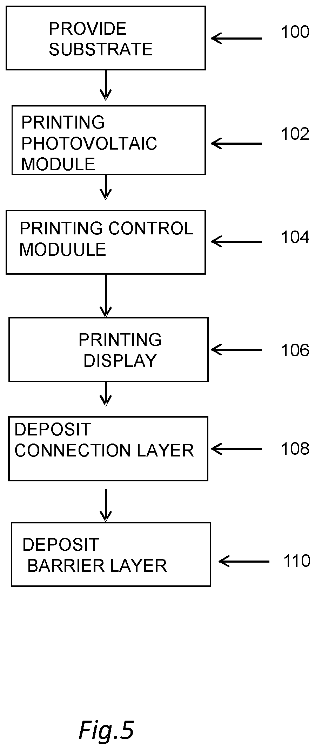

Below, with reference to figure 4, the process will be described for obtaining a label according to the present invention, the block diagram of which is shown in figure 5. Such a procedure starts with a first step 100 of providing a substrate 10, preferably of the type described above. Such substrate 10 may be transparent or opaque. In an embodiment of the present invention, the label is printed directly on the packaging (e.g. a plastic bottle or paper box), in which case the substrate is the surface of the packaging itself. Alternatively the substrate could be made of (or including) other materials, e.g. metal foils, rubber, self-adhesive substrate, tattoo paper.

Figure 3 shows a sectional view of the label 1, i.e. not included in the scope of present invention, in which the substrate 10 is present preferably a plastic sheet or bottle, onto which, in step 102 the photovoltaic module is printed. Between the photovoltaic modules 2 in steps 104 and 106 the control module 4, preferably comprising at least a low power supply thin film transistor, and the display 6 are printed, respectively, the latter preferably provided in the form of a layer of electrically addressable material, e.g. and electrochromic material. Alternatively the layer could be made of any other electrically addressable material, e.g. electroluminescent material.

A fundamental limit connected with organic electronic printing (steps 102 - 106 described above) on thin (10-200 µm) and ultrathin (less than 10 µm) plastic supports is connected with the maximum temperature of the printing process. Typically, to perform such printing, thermal heating processes are required, which are not compatible with the thin layer of plastic substrate used in the packaging, since such a layer would be heat sensitive. The optimisation of the organic electronic printing process is closely connected with the annealing processes, which typically require temperatures of over 100°C, necessary for optimising the performance of the printed devices, for example, improving the mobility of charge carriers, de-absorbing contaminants and obtaining the desired morphology of the support layer.

In the printing operations 102-106 described above, ink is used which is in itself known, to which, before performing the printing itself, dopants are added, preferably precursors of benzimidazole and benzimidazoline or caesium or lithium salts.

Thanks to the use of these particular chemical dopants, optimised electronics are obtained, printed directly at room temperature or however at low temperatures compatible with the substrate 10 (preferably lower than 70°C), in which only the evaporation of the ink solvent is required.

The control module 4 is provided to send control signals to the display 6 so that predetermined messages are shown on the display 6.

The control module 4 and the display 6 are in electrical contact with the photovoltaic module 2 for allowing its supply by the latter.

Above the control module 4 and the display 6, in step 108, an electrical interconnecting layer 12 is provided, through the holes (see Figure 4) preferably of ion-gel or solid electrolyte type, which allows the control module 4 to perform a low voltage control of the display 6, i.e. allowing the control module 4 to send control signals to the display 6.

Alternatively, the control module 4 is provided through at least one thin film transistor comprising semiconductor metal oxides such as, for example, ZnO, IZO, IGZO.

Finally, in step 110, on top of all the underlying layers, a barrier layer 14 is deposited, preferably oxide/polymer multilayer, for example silica and alumina for the inorganic layer and EVA, ETFE, PET or PEN for the organic layer, so as to protect the underlying layers from oxygen and water vapour.

Figure 4 shows a preferred embodiment of the invention wherein similar layers are indicated with the same reference numbers. As represented on this Figure, only the display 6 is placed between two photovoltaic modules 2 above the substrate 10. Above the photovoltaic modules 2 and the display 6 an insulating layer 16 is first deposited, having a predetermined pattern, i.e. a plurality of holes 16a placed in correspondence of the display 6 and subsequently the control module 4 is deposited which, through the holes 16a, comes into contact with the display 6 below. Finally, above the control module 4 the barrier layer 14 is deposited.

Therefore, in this embodiment, during use, there will be the front display 6 and the control module 4 behind it.

The label 1 according to the present invention is recyclable because all the electronic components are made with plastic electronic materials or easily separable from plastic (metallisations of silver or other metals).

The active label 1 is also recyclable because the materials of which each of its components are comprised, i.e. the photovoltaic module 2, the control module 4 and the display 6 are characterised by a low melting temperature (comprised between 200 and 400 °C). In this way, any traces of non-plastic materials (metals, metal oxides, etc.) present in the label 1 can be removed by filtering, in a known way, through techniques for the purification of recycled plastic.

The scope of the present invention is defined by the appended claims.

## Claims

1. Packaging label (1) comprising:
- a flexible substrate (10);
- a printed display (6) above the substrate (10), the display comprising an electrically addressable layer of ink;
- a printed control module (4) above the substrate, in electrical contact with the display (6) and arranged to control the operating of such display (6), the control module including a layer comprising ink mixed with dopants;
- at least a printed photovoltaic module (2) above the substrate (10) and next to the display (6) and arranged to supply the display (6) and the control module (4), the photovoltaic module including a layer comprising ink mixed with dopants, **characterised by** further comprising an insulating layer (16) placed above the display (6) and on which the control module (4) is placed, said insulating layer (16) having a plurality of holes (16a) placed in correspondence of the display (6) and arranged to allow the electric contact between said display (6) and the control module (4).

2. Packaging label according to claim 1 wherein the substrate is made of one or more material selected in the following: plastic, paper, metal foils, rubber, self-adhesive substrate, tattoo paper.

3. Packaging label according to any preceding claim wherein the display includes a layer of electrochromic ink.

4. Packaging label according to any preceding claim wherein the substrate has a thickness between 1 and 100 µm.

5. Packaging label according to any preceding claim, wherein the dopants include a precursor of benzimidazole or benzimidazoline or caesium or lithium salts.

6. Packaging label according to any preceding claim, wherein the electric contact between the control module (4) and the display (6) comprises an inter-connecting layer (12) of ion-gel or solid electrolyte, the inter-connecting layer having also the function of Ion reservoir for the electrochromic display and/or gate medium for the transistors in the control unit.

7. Packaging label according to any preceding claim, wherein the control module (4) comprises a low-voltage organic thin layer transistor.

8. Packaging label Label according to any of the claims 1 to 6, wherein the control module (4) comprises at least a thin film transistor comprising semiconductor metal oxides.

9. Packaging label according to any preceding claim, further comprising a barrier layer (14) placed above the control module (4).

10. Method of obtaining a packaging label (1) for packaging comprising the steps of:
- printing (102) on a substrate (10) at least one photovoltaic module (2);
- printing (104, 106), next to the photovoltaic module (2), a display (6);
- depositing an insulating layer (16) above the display (6), the insulating layer (16) having a plurality of holes (16a) placed in correspondence of the display (6);
- printing a control module (4) above the insulating layer (16), arranging an electrical interconnection through the holes adapted to allow the display (6) to electrically contact the control module (4) and to allow the control module (4) to control the display (6); wherein the printing steps (102, 104, 106) of the photovoltaic module (2), the control module (4) and the display (6) comprise the step of mixing a printing ink with dopants.

11. Method according to claim 10 further comprising the step of depositing (110) a barrier layer (14), arranged to protect the underlying layers.

12. Method of labelling a package including the steps of claim 10, wherein the substrate is the surface of the package.

13. A packaging including a packaging label according to any of claims 1-9.

## Patentansprüche

1. Ein Verpackungsetikett (1), das Folgendes beinhaltet:
- ein flexibles Substrat (10);
- eine gedruckte Anzeige (6) oberhalb des Substrats (10), wobei die Anzeige eine elektrisch adressierbare Tintenschicht beinhaltet;
- ein gedrucktes Steuermodul (4) oberhalb des Substrats, das in elektrischem Kontakt mit der Anzeige (6) steht und angeordnet ist, um den Betrieb dieser Anzeige (6) zu steuern, wobei das Steuermodul eine Schicht umfasst, die mit Dotierstoffen gemischte Tinte beinhaltet;
- mindestens ein gedrucktes photovoltaisches Modul (2) oberhalb des Substrats (10) und neben der Anzeige (6), und das angeordnet ist, um die Anzeige (6) und das Steuermodul (4) zu versorgen, wobei das photovoltaische Modul eine Schicht beinhaltet, die mit Dotierstoffen gemischte Tinte beinhaltet,
**dadurch gekennzeichnet, dass** es ferner eine Isolierschicht (16) beinhaltet, die oberhalb der Anzeige (6) eingerichtet ist und auf der das Steuermodul (4) eingerichtet ist, wobei die Isolierschicht (16) eine Vielzahl von Löchern (16a) aufweist, die in Übereinstimmung mit der Anzeige (6) eingerichtet sind und angeordnet sind, um den elektrischen Kontakt zwischen der Anzeige (6) und dem Steuermodul (4) zu erlauben.

2. Verpackungsetikett gemäß Anspruch 1, wobei das Substrat aus einem oder mehreren Materialien ist, die aus Folgendem ausgewählt sind: Kunststoff, Papier, Metallfolien, Gummi, selbstklebendem Substrat, Tätowierpapier.

3. Verpackungsetikett gemäß einem der vorhergehenden Ansprüche, wobei die Anzeige eine Schicht elektrochromer Tinte umfasst.

4. Verpackungsetikett gemäß einem der vorhergehenden Ansprüche, wobei das Substrat eine Dicke zwischen 1 und 100 µm aufweist.

5. Verpackungsetikett gemäß einem der vorhergehenden Ansprüche, wobei die Dotierstoffe einen Vorläufer von Benzimidazol oder Benzimidazolin oder Cäsium- oder Lithiumsalze umfassen.

6. Verpackungsetikett gemäß einem der vorhergehenden Ansprüche, wobei der elektrische Kontakt zwischen dem Steuermodul (4) und der Anzeige (6) eine Verbindungsschicht (12) aus lonengel oder Festelektrolyt beinhaltet, wobei die Verbindungsschicht auch die Funktion eines lonenreservoirs für die elektrochrome Anzeige und/oder eines Gate-Mediums für die Transistoren in der Steuereinheit aufweist.

7. Verpackungsetikett gemäß einem der vorhergehenden Ansprüche, wobei das Steuermodul (4) einen organischen Dünnschichttransistor mit niedriger Spannung beinhaltet.

8. Verpackungsetikett gemäß einem der Ansprüche 1 bis 6, wobei das Steuermodul (4) mindestens einen Dünnschichttransistor mit Halbleitermetalloxiden beinhaltet.

9. Verpackungsetikett gemäß einem der vorhergehenden Ansprüche, das ferner eine Sperrschicht (14) beinhaltet, die oberhalb des Steuermoduls (4) eingerichtet ist.

10. Ein Verfahren zum Erhalten eines Verpackungsetiketts (1) für Verpackungen, das die folgenden Schritte beinhaltet:
- Drucken (102) mindestens eines photovoltaischen Moduls (2) auf ein Substrat (10);
- Drucken (104, 106), neben dem photovoltaischen Modul (2), einer Anzeige (6);
- Aufbringen einer Isolierschicht (16) oberhalb der Anzeige (6), wobei die Isolierschicht (16) eine Vielzahl von Löchern (16a) aufweist, die in Übereinstimmung mit der Anzeige (6) eingerichtet sind;
- Drucken eines Steuermoduls (4) oberhalb der Isolierschicht (16), Anordnen einer elektrischen Verbindung durch die Löcher, die angepasst ist, um der Anzeige (6) zu erlauben, das Steuermodul (4) elektrisch zu kontaktieren und um dem Steuermodul (4) zu erlauben, die Anzeige (6) zu steuern;
wobei die Druckschritte (102, 104, 106) des photovoltaischen Moduls (2), des Steuermoduls (4) und der Anzeige (6) den Schritt des Mischens einer Druckfarbe mit Dotierstoffen beinhalten.

11. Verfahren gemäß Anspruch 10, das ferner den Schritt des Aufbringens (110) einer Sperrschicht (14) beinhaltet, die zum Schutz der darunter liegenden Schichten angeordnet ist.

12. Verfahren zum Etikettieren einer Verpackung, das die Schritte gemäß Anspruch 10 umfasst, wobei das Substrat die Oberfläche der Verpackung ist.

13. Eine Verpackung, die ein Verpackungsetikett gemäß einem der Ansprüche 1-9 umfasst.

## Revendications

1. Étiquette d'emballage (1) comprenant :
- un substrat flexible (10) ;
- un afficheur imprimé (6) au-dessus du substrat (10), l'afficheur comprenant une couche d'encre adressable électriquement ;
- un module de commande imprimé (4) au-dessus du substrat, en contact électrique avec l'afficheur (6) et agencé pour commander le fonctionnement de cet afficheur (6), le module de commande incluant une couche comprenant de l'encre mélangée avec des dopants ;
- au moins un module photovoltaïque imprimé (2) au-dessus du substrat (10) et à côté de l'afficheur (6) et agencé pour alimenter l'afficheur (6) et le module de commande (4), le module photovoltaïque incluant une couche comprenant de l'encre mélangée avec des dopants,
**caractérisée en ce qu'**elle comprend en outre une couche isolante (16) placée au-dessus de l'afficheur (6) et sur laquelle le module de commande (4) est placé, ladite couche isolante (16) ayant une pluralité de trous (16a) placés en correspondance de l'afficheur (6) et agencés pour permettre le contact électrique entre ledit afficheur (6) et le module de commande (4).

2. Étiquette d'emballage selon la revendication 1 dans laquelle le substrat est réalisé en un ou plusieurs matériaux sélectionnés dans ce qui suit : plastique, papier, feuilles métalliques, caoutchouc, substrat auto-adhésif, papier de tatouage.

3. Étiquette d'emballage selon n'importe quelle revendication précédente, dans laquelle l'afficheur inclut une couche d'encre électrochrome.

4. Étiquette d'emballage selon n'importe quelle revendication précédente, dans laquelle le substrat a une épaisseur comprise entre 1 et 100 µm.

5. Étiquette d'emballage selon n'importe quelle revendication précédente, dans laquelle les dopants incluent un précurseur de benzimidazole ou de benzimidazoline ou des sels de césium ou de lithium.

6. Étiquette d'emballage selon n'importe quelle revendication précédente, dans laquelle le contact électrique entre le module de commande (4) et l'afficheur (6) comprend une couche d'interconnexion (12) de gel ionique ou d'électrolyte solide, la couche d'interconnexion ayant aussi la fonction de réservoir d'ions pour l'afficheur électrochrome et/ou de milieu de grille pour les transistors dans l'unité de commande.

7. Étiquette d'emballage selon n'importe quelle revendication précédente, dans laquelle le module de commande (4) comprend un transistor à couche mince organique basse tension.

8. Étiquette d'emballage selon n'importe lesquelles des revendications 1 à 6, dans laquelle le module de commande (4) comprend au moins un transistor à couche mince comprenant des oxydes métalliques semi-conducteurs.

9. Étiquette d'emballage selon n'importe quelle revendication précédente, comprenant en outre une couche barrière (14) placée au-dessus du module de commande (4).

10. Procédé d'obtention d'une étiquette d'emballage (1) pour emballage comprenant les étapes consistant à :
- imprimer (102) sur un substrat (10) au moins un module photovoltaïque (2) ;
- imprimer (104, 106), à côté du module photovoltaïque (2), un afficheur (6) ;
- déposer une couche isolante (16) au-dessus de l'afficheur (6), la couche isolante (16) ayant une pluralité de trous (16a) placés en correspondance de l'afficheur (6) ;
- imprimer un module de commande (4) au-dessus de la couche isolante (16), agencer une interconnexion électrique à travers les trous adaptés pour permettre à l'afficheur (6) de venir en contact électrique avec le module de commande (4) et pour permettre au module de commande (4) de commander l'afficheur (6) ;
dans lequel les étapes consistant à imprimer (102, 104, 106) le module photovoltaïque (2), le module de commande (4) et l'afficheur (6) comprennent l'étape consistant à mélanger une encre d'impression avec des dopants.

11. Procédé selon la revendication 10, comprenant en outre l'étape consistant à déposer (110) une couche barrière (14), agencée pour protéger les couches sous-jacentes.

12. Procédé d'étiquetage d'un contenant d'emballage incluant les étapes de la revendication 10, dans lequel le substrat est la surface du contenant d'emballage.

13. Un emballage incluant une étiquette d'emballage selon n'importe lesquelles des revendications 1 à 9.
